# FASCICULE DE BREVET EUROPEEN

(11) **EP 1 348 039 B1**
(45) Date de publication et mention de la délivrance du brevet: **02.01.2013**
(21) Numéro de dépôt: 01996636.5
(22) Date de dépôt: 06.11.2001
(51) Int. Cl.: C23C 16/44, G05D 7/06

(54) **INSTALLATION DANS LAQUELLE EST REALISEE UNE OPERATION NECESSITANT UN CONTR LE DE L'ATMOSPHERE A L'INTERIEUR D'UNE ENCEINTE**
VORRICHTUNG, IN DER EINE OPERATION DURCHGEFÜHRT WIRD, DIE DIE KONTROLLE DER ATMOSPHÄRE IN EINER KAMMER ERFORDERT
INSTALLATION WHEREIN IS PERFORMED AN OPERATION REQUIRING CONTROL OF ATMOSPHERE INSIDE A CHAMBER

(30) Priorité: 16.11.2000 FR 0014793
(43) Date de publication de la demande: 01.10.2003
(73) Titulaire: L'AIR LIQUIDE, Société Anonyme pour l'Etude et l'Exploitation des Procédés Georges Claude, 75007 Paris (FR); Softal Electronic Erik Blumenfeld Gmbh & Co., 21107 Hamburg (DE)
(72) Inventeur: COCOLIOS, Panayotis, F-78830 Bullion (FR); COEURET, François, F-78280 Guyancourt (FR); DÖRING, Wolfgang, SOFTAL electronic, D-21107 Hamburg (DE); FÖRSTER, Franck, SOFTAL electronic, D-21107 Hamburg (DE); GELOT, Jean-Louis, F-78990 Elancourt (FR); MARTENS, Bernd, SOFTAL Electronic, 21107 Hamburg (DE); MELEN, Stéphane, F-27430 Herqueville (FR); PRINZ, Eckard, SOFTAL electronic, D-21107 Hamburg (DE); THONNELIER, Jean-Yves, F-78960 Voisins le Bretonneux (FR); VILLERMET, Alain, F-78220 Viroflay (FR)
(74) Mandataire: Mellul-Bendelac, Sylvie Lisette
(86) Numéro de dépôt international: PCT/FR2001/003421
(87) Numéro de publication internationale: WO 2002/040738

(56) Documents cités:
- EP-A- 0 622 474
- US-A- 5 464 657
- US-A- 5 851 293
- US-A- 5 928 428
- US-A- 6 143 080

## Description

L'invention concerne une installation dans laquelle est réalisée une opération nécessitant un contrôle de l'atmosphère à l'intérieur d'une enceinte, et concerne en particulier une installation de traitement de surface d'un substrat en défilement, notamment un film polymère, plus précisément pour mettre en oeuvre un procédé selon lequel on soumet le substrat à une décharge électrique dans un mélange gazeux autre que l'air.

Le document US-6 143 080 illustre le cas d'un réacteur de traitement de wafers dont l'objectif technique initial est de réaliser des débits de gaz et des concentrations substantiellement constantes et uniformes à la surface des substrats pour obtenir de meilleurs résultats de qualité, reproductibilité, et constance d'épaisseur des films déposés.

Dans le domaine du traitement de surface de substrats en défilement, il est connu que l'on peut améliorer les performances des films (énergie de surface, caractéristiques d'adhésion...), notamment de films polyoléfine, par dépôt sur leur surface d'une faible quantité d'oxyde de silicium. A cette fin, selon ces procédés connus, on soumet le substrat (le film) en matériau polymère à une décharge électrique à barrière diélectrique à une pression supérieure à 10kPa, et simultanément ou postérieurement, on expose le substrat ainsi traité à une atmosphère consistant en un mélange gazeux actif, mélange actif contenant par exemple un gaz susceptible de provoquer la formation du dépôt d'oxyde de silicium, tel qu'un silane (le plus souvent un hydrocarbure de silicium halogéné ou non, ou un alkoxysilane).

De manière générale, le traitement par décharge électrique dans un mélange gazeux est réalisé en continu, à des vitesses de défilement du substrat allant d'une dizaine à plusieurs centaines de mètres par minute, habituellement dans une enceinte comprenant outre des électrodes, un dispositif d'injection du mélange gazeux actif et des dispositifs d'aspiration des effluents gazeux. La décharge est créée entre les électrodes de l'enceinte disposées d'un côté de l'une des surfaces du substrat et une contre-électrode disposée du côté de la surface opposée.

A titre illustratif de cet état de la technique des traitements de surface de films polymères en défilement on pourra par exemple se reporter au document EP-622474.

Plus précisément, le substrat à traiter est appliqué contre la périphérie d'un rouleau métallique recouvert d'un matériau diélectrique utilisé en tant que contre-électrode relié à la terre, le long d'un arc de cercle de plusieurs dizaines de degrés, par exemple le long de la moitié de la circonférence du rouleau. Un capot délimitant l'enceinte recouvre une partie de la longueur de cet arc de cercle, approximativement centrale, en s'étendant suffisamment à distance de cet arc pour pouvoir contenir les différents éléments nécessaires au traitement ; la longueur du rouleau dans sa direction axiale est légèrement supérieure à la largeur du substrat, et la longueur de l'enceinte dans la même direction est elle-même en général légèrement supérieure à la largeur du substrat.

Par ailleurs, industriellement, le traitement est souvent effectué en continu 24 heures sur 24, et l'appareillage sous capot doit fonctionner en système ouvert. Malgré les dispositifs d'aspiration et d'injection de mélange gazeux actif, l'air entraîné en couche limite à la surface de la bande ne peut être complètement empêché d'entrer sous le capot. Le traitement est alors réalisé dans un mélange gazeux constitué du mélange gazeux actif injecté et d'air dont les proportions sont mal contrôlées.

Les mélanges gazeux actifs mis en oeuvre sont généralement des mélanges binaires ou ternaires constitués d'azote comme gaz porteur et de gaz actifs en proportions de l'ordre de quelques centaines de ppm. Les travaux réalisés pour l'optimisation du procédé montrent clairement que la teneur du mélange en chacun des gaz actifs est un paramètre essentiel qu'il convient de contrôler de la manière la plus rigoureuse possible. Par ailleurs, certains gaz actifs tels les silanes, ont la propriété de réagir fortement avec l'air pour donner des sous-produits, notamment solides et gazeux.

Il est donc nécessaire de disposer d'une installation de traitement capable de bien contrôler l'atmosphère gazeuse de traitement en réduisant le plus possible la quantité d'air entrant.

On connaît notamment (voir par exemple le brevet européen cité plus haut) des installations de mise en oeuvre de tels procédés comportant des injecteurs de mélange gazeux actif au coeur de la décharge et des fentes d'aspiration en entrée et en sortie de l'enceinte. Les débits d'injection et d'aspiration sont réglés de telle sorte que la quantité d'air entrant soit minimisée. Toutefois, les teneurs minimales en air atteintes sous le capot restent élevées en comparaison des teneurs en gaz actifs dans le mélange injecté. Aussi, lorsque le niveau souhaité de traitement exige que le mélange gazeux contienne un gaz oxydant à une faible teneur, un ajout mal contrôlé d'une certaine quantité d'air (et donc d'oxygène, gaz oxydant) au mélange gazeux entraîne une mauvaise maîtrise de la qualité du traitement. Le contrôle de la composition du mélange gazeux actif peut donc se révéler insuffisant avec ce type d'installation.

L'invention a pour but de remédier à cet inconvénient, et plus particulièrement de proposer une installation améliorée du type précité (dans laquelle est réalisée une opération nécessitant un contrôle de l'atmosphère à l'intérieur d'une enceinte), et dans le cas particulier des traitements de surface de substrats en défilement de proposer une installation telle que le contrôle et la gestion des gaz soient possibles tant pour les gaz entrant que pour les gaz sortant, par suite du fait que :
- l'air entraîné à la surface du substrat est empêché d'entrer dans l'enceinte de traitement ;
- le mélange gazeux actif est injecté à l'intérieur de l'enceinte et ainsi utilisé de manière optimale pour le traitement proprement dit ;
- les éventuels effluents gazeux sont collectés afin d'être traités avant leur remise à l'air.

A cette fin, l'invention concerne tout d'abord une installation dans laquelle est réalisée une opération nécessitant un contrôle de l'atmosphère à l'intérieur d'une l'enceinte, opération effectuée en présence d'un mélange gazeux pouvant dégager des effluents, comportant :
- des dispositifs d'entrée et de sortie attenant à l'enceinte pour s'opposer respectivement à une entrée d'air dans l'enceinte et à une sortie d'effluents gazeux de celle-ci ;
- un dispositif d'aspiration comportant une conduite débouchant dans l'enceinte ; et se caractérisant en ce qu'elle comporte :
- des moyens de régulation du débit de gaz aspiré par ledit dispositif d'aspiration afin de maintenir entre l'intérieur de l'enceinte et l'atmosphère environnante une différence de pression approximativement nulle.

On entend par « approximativement nulle » selon la présente invention une différence de pression (en positif ou négatif) n'excédant pas quelques dizaine de Pa voire 100 Pa. Mais on préférera selon la présente invention se situer dans des différences de pression n'excédant pas 50 Pa voire même inférieures à 10 Pa.

L'installation selon l'invention peut en outre présenter une ou plusieurs des caractéristiques suivantes :
- le dispositif d'entrée comprend des moyens pour injecter un gaz inerte en formant un couteau gazeux en amont de l'enceinte, des moyens pour créer une surpression refoulant le gaz inerte à distance de l'enceinte en formant piston empêchant une entrée d'air dans l'enceinte, et des moyens pour canaliser l'air à distance de l'enceinte.
- le dispositif de sortie comprend des moyens pour injecter un gaz inerte en formant un couteau gazeux en aval de l'enceinte, des moyens pour créer une surpression refoulant le gaz inerte vers l'enceinte en formant piston s'opposant à l'entraînement des effluents à l'extérieur de l'enceinte, et des moyens pour canaliser vers l'enceinte les effluents sortant éventuellement de celle-ci.
- lesdits moyens pour injecter le gaz inerte en formant un couteau gazeux comprennent une fente d'injection de gaz à parois planes débouchant à l'intérieur du dispositif d'entrée ou de sortie concerné.
- lesdits moyens pour créer une surpression refoulant le gaz en formant piston comprennent des gorges ouvertes en vis-à-vis de l'espace intérieur du dispositif d'entrée ou de sortie concerné et formant un labyrinthe.
- lesdits moyens pour canaliser comprennent un canal, séparé desdits moyens pour injecter du gaz par une cloison, et ouvert en vis-à-vis de l'espace intérieur du dispositif d'entrée ou de sortie concerné.
- lesdits moyens pour canaliser comprennent un canal creusé dans une face d'une plaque écartée d'une autre pièce par un espace formant une fente d'injection de gaz inerte.
- le rapport entre la longueur et la hauteur du canal est au moins égal à 3 et préférentiellement au moins égal à 6.
- l'installation comporte en outre des dispositifs latéraux extérieurs à l'enceinte comprenant au moins des moyens pour créer une surpression refoulant le gaz à distance de l'enceinte en formant piston empêchant une entrée d'air dans l'enceinte, et le cas échéant également des moyens pour injecter un gaz inerte en formant un couteau gazeux latéralement à l'enceinte ainsi que des moyens pour canaliser l'air à distance de l'enceinte.
- l'installation comporte un deuxième dispositif d'aspiration en aval du dispositif de sortie .
- elle comporte un automate permettant de coordonner le fonctionnement de tout ou partie des éléments de l'installation.
- l'automate est apte à optimiser les débits de gaz injectés (qu'il s'agisse du gaz inerte ou du mélange gazeux utilisé pour l'opération proprement dite) en fonction de mesures de teneur en oxygène permettant d'évaluer les entrées d'air, effectuées en différents points à l'intérieur de l'enceinte, et/ou en fonction d'une mesure de pression différentielle entre l'intérieur de l'enceinte et l'atmosphère environnante.
- l'opération réalisée dans l'enceinte est une opération de traitement de surface d'un substrat en défilement par une décharge électrique en présence dudit mélange gazeux pouvant dégager des effluents.
- l'opération réalisée dans l'enceinte est une opération de réticulation d'un enduit (par exemple une encre ou un vernis) par rayonnement Ultra Violet (« UV Curing ») ou par faisceau d'électrons (« Electron Beam » dans la littérature) en présence d'un mélange gazeux inerte, par exemple à base d'azote.

La notion de « couteau gazeux » selon l'invention doit s'entendre comme recouvrant de façon générale des géométries variées d'injection gazeuse, et donc pas nécessairement des injections de forme très étroite et à vitesse de gaz extrêmement élevées (comme on l'entend parfois dans certaines littératures derrière l'expression « couteau »).

On comprendra mieux toutes les caractéristiques et avantages de l'invention en examinant une de ses applications pratiques, avec le cas des installations de traitement de surface d'un substrat en défilement, par une décharge électrique en présence d'un mélange gazeux pouvant dégager des effluents.

La présente invention concerne en effet également une installation de traitement de surface d'un substrat en défilement, par une décharge électrique en présence d'un mélange gazeux pouvant dégager des effluents, comportant un support de substrat contre une région duquel est appliqué le substrat, et des électrodes à proximité du support formant contre-électrode, caractérisée en ce qu'elle comporte aussi :
- une enceinte adjacente au support sur au moins la largeur du substrat et le long d'au moins une partie de ladite région, dans laquelle sont logées les électrodes ;
- des dispositifs d'entrée et de sortie attenant à l'enceinte pour s'opposer respectivement à une entrée d'air dans l'enceinte et à une sortie d'effluents gazeux de celle-ci ;
- un dispositif d'aspiration comportant une conduite débouchant dans l'enceinte ; et
- des moyens de régulation du débit de gaz aspiré par ledit dispositif d'aspiration afin de maintenir entre l'intérieur de l'enceinte et l'atmosphère environnante une différence de pression approximativement nulle.

Grâce à cette conception, l'enceinte est suffisamment isolée de l'extérieur, tout en conservant un fonctionnement en système ouvert, de telle sorte que l'installation est capable de traiter un substrat défilant à vitesse élevée.

L'installation de traitement de surface selon l'invention peut en outre présenter une ou plusieurs des caractéristiques suivantes :
- l'installation comporte un collecteur d'alimentation en mélange gazeux relié aux électrodes pour injecter au sein de celles-ci le mélange gazeux contre le substrat.
- le dispositif d'entrée comprend des moyens pour injecter un gaz inerte contre le substrat en formant un couteau gazeux en amont de l'enceinte, des moyens pour créer une surpression refoulant le gaz inerte à distance de l'enceinte en formant piston empêchant une entrée d'air dans l'enceinte, et des moyens pour canaliser l'air à distance de l'enceinte.
- le dispositif de sortie comprend des moyens pour injecter un gaz inerte contre le substrat en formant un couteau gazeux en aval de l'enceinte, des moyens pour créer une surpression refoulant le gaz inerte vers l'enceinte en formant piston s'opposant à l'entraînement des effluents par le substrat, et des moyens pour canaliser vers l'enceinte les effluents sortant éventuellement de celle-ci.
- elle comporte en outre des dispositifs latéraux extérieurs à l'enceinte comprenant au moins des moyens pour créer une surpression refoulant le gaz à distance de l'enceinte en formant piston empêchant une entrée d'air dans l'enceinte, et le cas échéant des moyens pour injecter un gaz inerte contre le support en formant un couteau gazeux latéralement à l'enceinte, ainsi que des moyens pour canaliser l'air à distance de l'enceinte.
- lesdits moyens pour injecter du gaz inerte en formant un couteau gazeux comprennent une fente d'injection de gaz à parois planes et débouchant à l'extérieur en vis-à-vis du support (la fente présente avantageusement une épaisseur de quelques dixièmes de millimètre).
- lesdits moyens pour créer une surpression refoulant le gaz en formant piston comprennent des gorges ouvertes en vis-à-vis du support et formant un labyrinthe.
- lesdits moyens pour canaliser comprennent un canal, séparé par une cloison desdits moyens pour injecter du gaz inerte, et ouvert en vis-à-vis du support.
- lesdits moyens pour canaliser comprennent un canal creusé dans une face d'une plaque écartée d'une autre pièce par un espace formant une fente d'injection de gaz inerte.
- le rapport entre la longueur (dans le sens d'avancement du substrat) et la hauteur du canal est au moins égale à 3, préférentiellement au moins égal à 6.
- le support de substrat est un rouleau tournant, et la région contre laquelle est appliqué le substrat est une région en arc de cercle.
- les moyens de régulation de débit aspiré comprennent une vanne de régulation dans la conduite d'aspiration débouchant dans l'enceinte, et un circuit de pilotage comprenant un capteur de pression pour commander la vanne.
- les moyens de régulation de débit aspiré comprennent des moyens de régulation de la vitesse de rotation du ventilateur d'aspiration (par exemple du type variateur de fréquence ou potentiomètre), et un circuit de pilotage comprenant un capteur de pression pour commander la vitesse de rotation du ventilateur d'aspiration.
- elle comporte un automate permettant de coordonner le fonctionnement de tout ou partie des éléments de l'installation.
- l'automate est apte à optimiser les débits de gaz injectés (qu'il s'agisse du gaz inerte ou du mélange gazeux utilisé pour le traitement de surface proprement dit) en fonction de mesures de teneur en oxygène permettant d'évaluer les entrées d'air, effectuées en différents points à l'intérieur de l'enceinte, et/ou en fonction d'une mesure de pression différentielle entre l'intérieur de l'enceinte et l'atmosphère environnante.
- elle comporte un deuxième dispositif d'aspiration, en aval du dispositif de sortie.
- les électrodes sont reliées à une alimentation dite haute tension et haute fréquence.

D'autres caractéristiques et avantages de l'invention ressortiront de la description qui va suivre, d'une forme de réalisation de l'invention donnée à titre d'exemple non limitatif, illustrée par les dessins joints dans lesquels :
- la figure 1 est une vue schématique de côté d'une partie d'une installation de traitement de surface selon l'invention, sur laquelle certains éléments de l'installation sont montrés au moins partiellement coupés, et
- la figure 2 est une coupe schématique de côté de l'un des dispositifs équipant l'installation de la figure 1.

L'installation illustrée par les figures comporte un rouleau support 1 formant contre-électrode relié à la terre, contre une partie de la périphérie duquel est appliqué un substrat S à traiter, par exemple une bande de polyoléfine ; ici, la bande est appliquée contre la périphérie du rouleau le long d'un arc de cercle de 180° environ .

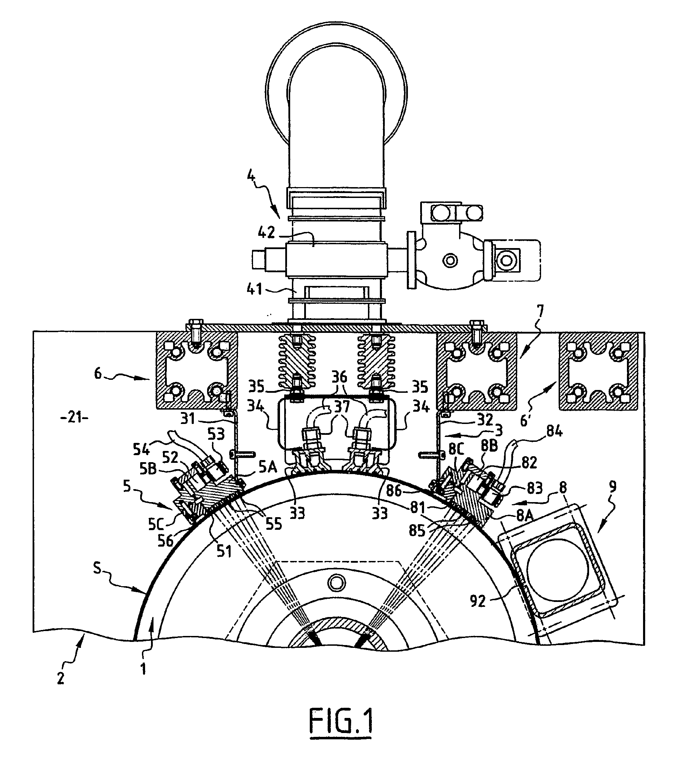

Le rouleau 1 est logé sur toute sa longueur dans un carter comportant une plaque avant 21 et une plaque arrière 21' (on ne visualise sur la figure 1 que la plaque avant 21 verticale), les plaques 21 et 21' étant rendues solidaires par un système de poutres 6, 7, 6' qui seront détaillées plus loin dans le cadre de la présente description.

On visualise par ailleurs sur la figure 1 la présence d'une enceinte 3, adjacente au rouleau 1, et s'étendant entre les poutres 6 et 7 et étant solidaire des plaques avant et arrière 21 et 21', le long d'une génératrice de celui-ci approximativement centrale sur l'arc sur lequel le substrat S est appliqué contre le rouleau, sur au moins toute la largeur du substrat. Cette enceinte 3 comporte elle-même deux parois longitudinales 31, 32 sensiblement parallèles au plan radial du rouleau contenant la génératrice centrale dudit arc, et est ouverte sur toute sa longueur le long de la partie de cet arc sur laquelle elle s'étend ; le substrat S défile à la base de l'enceinte 3, où il est mis en contact avec le mélange gazeux actif les effluents gazeux résultants devant ensuite être évacués de l'enceinte au moyen d'un dispositif d'aspiration 4 afin d'éviter leur rejet dans l'atmosphère.

Cependant, l'aspiration créant une dépression dans l'enceinte, et le système étant un système ouvert, sauf précautions particulières, cette dépression provoquera l'entrée dans l'enceinte d'un flux d'air proportionnel à la différence de pression entre l'extérieur (pression haute voisine de 1 atmosphère) et l'intérieur (pression basse due à l'aspiration).

Ainsi, pour contrôler l'ambiance de l'enceinte et plus précisément maintenir la pression dans l'enceinte à une valeur sensiblement identique à celle régnant à l'extérieur malgré la dépression due à la ventilation, il est essentiel de pouvoir gérer à la fois les gaz entrant dans l'enceinte et les gaz sortant de celle-ci.

Aussi, l'installation selon l'invention comporte, comme on va le voir, attenant à l'enceinte 3, des éléments extérieurs à l'enceinte d'une part du côté de l'entrée de celle-ci pour le substrat et du côté de la sortie du substrat, et d'autre part latéralement à celle-ci. Elle comporte par ailleurs des éléments intérieurs à l'enceinte, avec notamment au moins un dispositif d'aspiration.

Le rôle principal des éléments extérieurs à l'enceinte côté entrée du substrat est d'empêcher l'entrée d'air dans l'enceinte, au moyen d'un courant de gaz inerte dans les conditions de travail, tel que l'azote, tout en minimisant la consommation de ce gaz inerte.

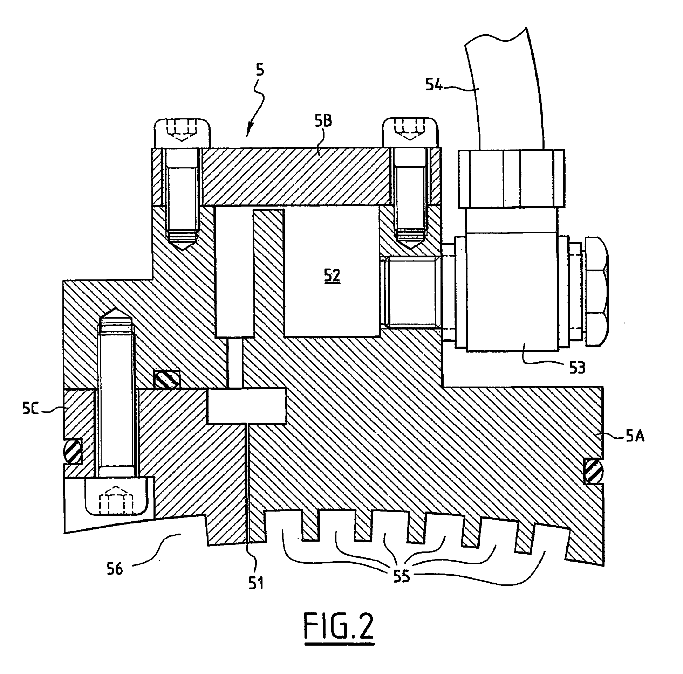

A cette fin, un bloc d'entrée 5 (figure 2) s'étendant sur toute la longueur de l'enceinte 3 est fixé à la base d'une tôle constituant la partie inférieure de la paroi longitudinale 31 de l'enceinte 3 côté entrée ; ce bloc d'entrée 5 est éloigné du substrat S d'une distance suffisante pour qu'il n'y ait aucun frottement du substrat contre sa base .

Le bloc 5 comporte une fente 51 d'injection d'azote à parois planes s'étendant dans les directions longitudinale et radiale du rouleau 1 et présentant une largeur ici de quelques dixièmes de millimètre (typiquement 0,3 à 0,5 millimètre), débouchant à l'extérieur en vis-à-vis du rouleau et ainsi du substrat en amont de l'entrée de l'enceinte 3, et dont la longueur est au moins égale à la largeur du substrat.

Le bloc 5 comporte une chambre d'introduction d'azote 52 reliée à la fente 51 par une succession de canaux de transmission d'azote et dans laquelle débouchent des raccords d'alimentation en azote 53 fixés dans le bloc 5 et se succédant le long de celui-ci ; ces raccords sont reliés par des conduits respectifs 54 à un collecteur d'alimentation en azote 6 fixé à la partie supérieure de la tôle 31 et à la partie supérieure des plaques 21 et 21', collecteur dont une paroi constitue, dans le prolongement vers le haut de la tôle 31, la partie supérieure de la paroi longitudinale de l'enceinte 3.

Le collecteur d'alimentation en azote 6 est relié à une source d'azote au moyen d'une conduite non représentée sur les dessins.

En outre, le bloc d'entrée 5 comporte, en aval de la fente 51, plusieurs gorges 55 de quelques millimètres de profondeur s'étendant longitudinalement dans le bloc, ouvertes en vis-à-vis du rouleau 1 et ainsi du substrat S, se succédant dans la direction du déplacement du substrat ; ces gorges, situées au voisinage de la fente 51, séparées de celle-ci et entre elles par des cloisons minces, forment un labyrinthe et créent une zone de surpression dans le sens de défilement du substrat, ce qui refoule l'azote plus en amont en formant piston pour le flux d'air que l'on souhaite empêcher d'entrer.

De plus, le bloc d'entrée 5 comporte, en amont de la fente 51, un canal 56 avantageusement de quelques millimètres de profondeur s'étendant longitudinalement dans le bloc, ouvert en vis-à-vis du rouleau et ainsi du substrat et débouchant à l'extérieur en amont du bloc. Ce canal s'étend dans la direction du déplacement du substrat jusqu'à proximité immédiate de la fente 51 dont il est séparé par une cloison mince ; en canalisant à la fois le flux d'air entrant sous le bloc et le flux d'azote provenant de la fente, il améliore l'effet de piston de l'azote, de telle sorte que celui-ci repousse vers l'amont encore plus efficacement le flux d'air entrant.

Selon une mise en oeuvre préférée de l'invention, le rapport entre la longueur (dans le sens d'avancement du substrat) et la hauteur du canal 56 est au moins égal à 3, mais plus préférentiellement au moins égal à 6.

Un tel dimensionnement préférentiel se révèle tout à fait avantageux pour créer un effet piston efficace vers l'extérieur, et notamment selon toute vraisemblance décoller (et repousser) la couche limite d'air transportée par le substrat S. La combinaison de la fente 51, du labyrinthe formé par les gorges 55, et du canal 56 empêche efficacement l'air entraîné par le film d'entrer à l'intérieur de l'enceinte 3, tout en minimisant la consommation d'azote.

Sur le plan pratique, le bloc d'entrée 5 est réalisé sur le mode représenté ici en trois pièces 5A, 5B, 5C assemblées par vis ; dans une première de ces pièces 5A , sont usinés les canaux de transmission d'azote, des orifices dans lesquels sont montés les raccords d'alimentation en azote 53, et les gorges 55 ; une deuxième pièce 5B coiffe la précédente et constitue une paroi de certains des canaux de transmission et de la chambre d'introduction d'azote de celle-ci ; une troisième pièce 5C est une plaque dans une face de laquelle est creusé le canal 56 et qui est écartée de quelques dixièmes de millimètres de la première pièce 5A de manière que l'espace entre les deux pièces 5A, 5C forme la fente d'injection d'azote 51.

Bien que, si l'on se réfère à la direction de déplacement du substrat S, les transferts gazeux latéraux (mélange gazeux actif et/ou air) entre l'intérieur et l'extérieur de l'enceinte 3 soient faibles, il est préférable de réduire encore autant qu'il est possible les échanges également dans ces directions afin de préserver le contrôle de l'atmosphère dans la zone de traitement. A cette fin, chacune des parois latérales de l'enceinte 3 porte avantageusement des éléments similaires à ceux qui viennent d'être décrits, et en particulier un bloc latéral extérieur à l'enceinte, similaire au bloc d'entrée 5, et qui pour cette raison ne sera pas décrit en détail.

Chaque bloc latéral s'étend en arc de cercle autour du rouleau support 1 au moins d'une paroi longitudinale 31 à l'autre 32 de l'enceinte 3 ; il comporte une fente d'injection d'azote en couteau s'étendant en forme de segment de couronne circulaire et débouchant en vis-à-vis du rouleau, reliée, comme à fente 51 du bloc d'entrée 5, par des canaux, une chambre d'introduction d'azote, et un conduit d'alimentation, au collecteur d'alimentation en azote 6 ; il comporte aussi plusieurs gorges de quelques millimètres de profondeur s'étendant aussi en forme de segment de couronne circulaire et ouvertes en vis-à-vis du rouleau, se succédant en direction du bord latéral du substrat, entre la fente d'injection d'azote et la paroi latérale de l'enceinte 3 ; il comporte en outre du côté de la fente qui est opposé à celui où s'étendent les gorges, un canal de quelques millimètres de profondeur s'étendant circonférenciellement dans le bloc, ouvert en vis-à-vis du rouleau et débouchant à l'extérieur à l'opposé de la cavité 3.

Par ailleurs, le rôle principal des éléments intérieurs à l'enceinte 3 est d'injecter le mélange gazeux de traitement dans la zone où le substrat S doit être soumis à la décharge électrique, en minimisant les consommations de gaz injectés. A cette fin, sur le mode de réalisation illustré au niveau des figures 1 et 2, l'enceinte 3 renferme deux électrodes 33, disposées symétriquement de part et d'autre du plan central longitudinal de l'enceinte contenant la génératrice centrale de l'arc que forme le substrat contre le rouleau. Ces électrodes, reliées chacune par un conducteur électrique 34 à une borne d'alimentation 35 elle-même reliée à une alimentation haute tension et haute fréquence, servent en outre à l'injection du mélange gazeux actif et sont reliées à cette fin par des conduits 36 respectifs à un collecteur d'alimentation en mélange gazeux actif 7.

Grâce au fait que l'on injecte le mélange gazeux actif de traitement, à travers une fente d'injection située au sein des électrodes 33 directement dans la zone de décharge, tout le gaz injecté traverse la décharge, ce qui réduit à néant les éventuelles pertes à ce niveau ; ainsi on peut maintenir de manière optimisée, au moyen d'un renouvellement continu, la composition du mélange nécessaire pour obtenir la qualité de traitement désirée.

Plus précisément, les électrodes 33 sont des blocs métalliques ou céramiques s'étendant sur toute la longueur de l'enceinte 3 et fixés à celle-ci. Les blocs comportent chacun une chambre d'introduction de mélange gazeux actif reliée à des fentes d'injection par des canaux de transmission de mélange gazeux actif, et dans laquelle débouchent des raccords d'alimentation 37 en mélange gazeux actif fixés dans le bloc et se succédant le long de celui-ci, auxquels sont connectés les conduits d'alimentation 36. Les fentes d'injection, de quelques dixièmes de millimètres de profondeur, s'étendant longitudinalement dans le bloc et ouvertes en vis-à-vis du substrat, se succèdent dans la direction du déplacement de celui-ci.

Le collecteur d'alimentation en mélange gazeux actif 7 est agencé symétriquement au collecteur d'alimentation en azote 6 par rapport au plan central longitudinal de l'enceinte 3; une paroi de ce collecteur 7 constitue, dans le prolongement vers le haut de la tôle, la partie supérieure de la paroi longitudinale correspondante 32 de l'enceinte 3 ; le collecteur d'alimentation en mélange gazeux actif 7 est relié à une source de mélange gazeux actif au moyen d'une conduite non représentée.

Le rôle principal des éléments extérieurs à l'enceinte côté sortie du substrat S est d'empêcher les effluents gazeux créés par la décharge de sortir librement dans l'atmosphère.

A cette fin, le dispositif d'aspiration des effluents gazeux 4 est fixé également extérieurement à l'enceinte 3, au-dessus de celle-ci avec laquelle il communique par une ouverture de la paroi supérieure de l'enceinte constituant sa sortie pour les effluents gazeux; ce dispositif d'aspiration, compensant en terme de pression, les diverses injections de gaz (mélange gazeux de traitement injecté dans la zone de décharge, tout ou partie de l'azote injecté dans les couteaux d'entrée et de sortie, etc.), et dirige ici pour le mode de réalisation représenté les effluents vers un appareil de traitement à lit d'adsorbant (non représenté).

Plus précisément, le dispositif d'aspiration des effluents gazeux 4 comporte une conduite d'aspiration 41 fixée à la cloison supérieure de l'enceinte et débouchant dans celle-ci, une vanne de régulation 42 par exemple du type vanne-papillon disposée dans la conduite d'aspiration, et un circuit de pilotage (non représenté sur les dessins) comprenant un capteur de pression différentielle permettant d'évaluer la différence de pression entre l'intérieur de l'enceinte et l'atmosphère environnante, pour commander la vanne de régulation 42 vers l'ouverture ou la fermeture en fonction de la valeur de la pression différentielle mesurée par le capteur.

Selon une variante de l'invention, on agit, en fonction de la pression différentielle mesurée, sur le débit d'aspiration lui même (rotation de la turbine).

Grâce au circuit de pilotage, si, en fonction du débit d'aspiration mis en oeuvre et du débit total injecté, il se crée à l'intérieur de l'enceinte 3 soit une dépression, soit une surpression, par rapport à la pression de l'atmosphère environnante, le débit d'aspiration est régulé en fonction de la pression différentielle de telle manière que cette pression différentielle soit aussi faible que possible, et ainsi les échanges gazeux avec l'extérieur de l'enceinte (entrée d'air ou sortie d'effluents) sont minimisés.

Par ailleurs, le substrat S en défilement entraînant à sa surface une couche limite de gaz composés essentiellement d'effluents provenant de la décharge, il est nécessaire, pour des raisons de sécurité liées à la nature des effluents, de décoller cette couche limite et de la maintenir à l'intérieur de l'enceinte 3 afin que les gaz qu'elle contient soient collectés par le dispositif d'aspiration 4 décrit plus haut.

Pour cela, on met en oeuvre à la sortie de l'enceinte des éléments similaires à ceux qui sont à l'entrée de celle-ci. Un bloc de sortie 8 s'étendant sur toute la longueur de l'enceinte 3 est fixé à la base de la tôle constituant la partie inférieure de la paroi longitudinale 32 de l'enceinte côté sortie ; ce bloc de sortie 8 comporte une fente 81 d'injection d'azote à parois planes s'étendant dans les directions longitudinale et radiale du rouleau 1 et présentant une épaisseur de quelques dixièmes de millimètre (typiquement 0,3 à 0,5 millimètre), débouchant à l'extérieur en vis-à-vis du rouleau et ainsi du substrat en aval de la sortie de l'enceinte 3, et dont la longueur est au moins égale à la largeur du substrat ; le bloc de sortie 8 comporte une chambre d'introduction d'azote 82 reliée à la fente 81 par une succession de canaux de transmission d'azote et dans laquelle débouchent des raccords d'alimentation en azote 83 fixés dans le bloc 8 et se succédant le long de celui-ci ; ces raccords sont reliés par des conduits respectifs 84 à un collecteur d'alimentation en azote 6' fixé à l'extérieur de la cavité 3 ; ce collecteur d'alimentation en azote 6' est relié à la source d'azote au moyen d'une conduite non représentée.

En outre, le bloc de sortie 8 comporte, en aval de la fente, plusieurs gorges 85 de quelques millimètres de profondeur s'étendant longitudinalement dans le bloc, ouvertes en vis-à-vis du rouleau et ainsi du substrat, se succédant dans la direction du déplacement du substrat ; ces gorges, situées au voisinage de la fente, séparées de celle-ci et entre elles par des cloisons minces, forment un labyrinthe et créent une zone de surpression refoulant l'azote plus en amont en formant piston s'opposant à l'entraînement par le substrat en direction de l'extérieur des effluents contenus dans l'enceinte.

De plus, le bloc de sortie 8 comporte, en amont de la fente 81, un canal 86 également de quelques millimètres de profondeur s'étendant longitudinalement dans le bloc, ouvert en vis-à-vis du rouleau et ainsi du substrat et débouchant en amont du bloc sur la sortie de l'enceinte 3 pour le substrat ; ce canal 86 s'étend dans le sens du déplacement du substrat jusqu'à proximité immédiate de la fente 81 dont il est séparé par une cloison mince. Ainsi, le bloc de sortie 8, constitué sur le plan pratique comme le bloc d'entrée 5, et qui ne sera donc pas davantage décrit, associe une plaque 86 canalisant les effluents et optimisant l'effet piston, un couteau d'azote, et un labyrinthe refoulant l'azote vers l'enceinte de manière à établir l'effet piston à l'encontre des effluents.

Enfin, par mesure de sécurité supplémentaire, en aval du bloc de sortie 8, est disposé ici un deuxième dispositif d'aspiration 9 destiné à collecter d'éventuels résidus d'effluents gazeux. Ce deuxième dispositif d'aspiration 9 comporte, comme c'était le cas du dispositif 4, une conduite et un ventilateur d'aspiration. La conduite, présentant une section droite de forme générale carrée, a son axe longitudinal parallèle à celui du rouleau 1 et est disposée à proximité immédiate du substrat S ; la paroi latérale de cette conduite dont la longueur est au moins égale à la largeur du substrat, présente sur toute la largeur du substrat une fente 92 la traversant de part en part, et est fermée à l'une de ses extrémités tandis que son extrémité opposée est reliée au ventilateur d'aspiration (non représenté), susceptible d'assurer un débit de plusieurs centaines de mètres cubes par heure.

Un automate (non représenté) coordonne le fonctionnement de tout ou partie des éléments de l'installation afin de parfaitement optimiser les débits de gaz inerte injectés.

Selon un des modes de réalisation de l'invention, les valeurs des débits de gaz inerte sont fixées par une boucle de régulation dans laquelle le signal de régulation est fonction de mesures de teneur en oxygène permettant d'évaluer les entrées d'air, effectuées en différents points à l'intérieur de l'enceinte 3.

Comme on l'a vu précédemment, selon une variante de l'invention, on utilise un capteur de pression différentielle permettant d'évaluer la différence de pression entre l'intérieur de l'enceinte et l'atmosphère environnante, pour commander par l'automate la vanne de régulation 42 vers l'ouverture ou la fermeture en fonction de la valeur de la pression différentielle mesurée par le capteur.

Selon une autre variante de l'invention, on agit, en fonction de la pression différentielle mesurée, sur le débit d'aspiration lui même via la rotation de la turbine d'aspiration.

A titre illustratif, on a pu obtenir selon l'invention dans le cas d'une enceinte de traitement de surface de films de polypropylène les résultats suivants, dans les conditions opératoires suivantes :
- pour un 1^{er} exemple : une largeur de film polypropylène de 1m80, le film défilant à 90 m/minute, un débit de couteau d'azote en entrée de 25m³/h, et un débit de couteau d'azote en sortie de 5m³/h, un rapport entre longueur et hauteur de canal de 6, pour une injection de mélange gazeux de traitement (ici de l'azote) de 60m³/h.

On obtient pour ce premier exemple une différence de pression entre intérieur de l'enceinte et atmosphère environnante de +1 Pa, et moins de 100 ppm d'oxygène résiduel dans l'enceinte.
- pour un 2d exemple : une largeur de film polypropylène de 1m80, le film défilant cette fois à 300 m/minute, un débit de couteau d'azote en entrée de 60m³/h, et un débit de couteau d'azote en sortie de 10m³/h, un rapport entre longueur et hauteur de canal ici aussi de 6, pour une injection de mélange gazeux de traitement (ici de l'azote) de 30m³/h.

On obtient pour ce second exemple une différence de pression entre intérieur de l'enceinte et atmosphère environnante de +1 Pa, et ici encore moins de 100 ppm d'oxygène résiduel dans l'enceinte.

## Revendications

1. Installation dans laquelle est réalisée une opération nécessitant un contrôle de l'atmosphère à l'intérieur d'une enceinte (3), opération effectuée en présence d'un mélange gazeux pouvant dégager des effluents, comportant :
- des dispositifs d'entrée et de sortie (5, 8) attenant à l'enceinte pour s'opposer respectivement à une entrée d'air dans l'enceinte et à une sortie d'effluents gazeux de celle-ci ;
- un dispositif d'aspiration (4) comportant une conduite débouchant dans l'enceinte ; et **caractérisée en ce qu'**elle comporte :
- des moyens de régulation (42..) du débit de gaz aspiré par ledit dispositif d'aspiration afin de maintenir entre l'intérieur de l'enceinte et l'atmosphère environnante une différence de pression approximativement nulle.

2. Installation selon la revendication 1, **caractérisée en ce que** le dispositif d'entrée (5) comprend des moyens (51) pour injecter un gaz inerte en formant un couteau gazeux en amont de l'enceinte, des moyens (55) pour créer une surpression refoulant le gaz inerte à distance de l'enceinte en formant piston empêchant une entrée d'air dans l'enceinte, et des moyens (56) pour canaliser l'air à distance de l'enceinte.

3. Installation selon la revendication 1 ou 2, **caractérisée en ce que** le dispositif de sortie (8) comprend des moyens (81) pour injecter un gaz inerte en formant un couteau gazeux en aval de l'enceinte, des moyens (85) pour créer une surpression refoulant le gaz inerte vers l'enceinte en formant piston s'opposant à l'entraînement des effluents à l'extérieur de l'enceinte, et des moyens (86) pour canaliser vers l'enceinte les effluents sortant éventuellement de celle-ci.

4. Installation selon la revendication 2 ou 3, **caractérisée en ce que** lesdits moyens pour injecter du gaz inerte en formant un couteau gazeux comprennent une fente d'injection de gaz à parois planes débouchant à l'intérieur du dispositif d'entrée ou de sortie concerné.

5. Installation selon l'une quelconque des revendications 2 à 4, **caractérisée en ce que** lesdits moyens pour créer une surpression refoulant le gaz en formant piston comprennent des gorges ouvertes en vis-à-vis de l'espace intérieur du dispositif d'entrée ou de sortie concerné et formant un labyrinthe.

6. Installation selon l'une quelconque des revendications 2 à 5, **caractérisée en ce que** lesdits moyens pour canaliser comprennent un canal séparé desdits moyens pour injecter du gaz par une cloison, et ouvert en vis-à-vis de l'espace intérieur du dispositif d'entrée ou de sortie concerné.

7. Installation selon l'une quelconque des revendications 2 à 5, **caractérisée en ce que** lesdits moyens pour canaliser comprennent un canal (56, 86) creusé dans une face d'une plaque (5C, 8C) écartée d'une autre pièce (5A, 8A) par un espace formant une fente (51, 81) d'injection de gaz inerte.

8. Installation selon l'une quelconque des revendications 6 ou 7, **caractérisée en ce que** le rapport entre la longueur et la hauteur du canal est au moins égal à 3, préférentiellement au moins égal à 6.

9. Installation selon l'une quelconque des revendications 1 à 8, **caractérisée en ce qu'**elle comporte en outre des dispositifs latéraux extérieurs à l'enceinte (3) comprenant au moins des moyens pour créer une surpression refoulant le gaz à distance de l'enceinte en formant piston empêchant une entrée d'air dans l'enceinte, et le cas échéant également des moyens pour injecter un gaz inerte en formant un couteau gazeux latéralement à l'enceinte, ainsi que des moyens pour canaliser l'air à distance de l'enceinte.

10. Installation selon l'une quelconque des revendications 1 à 9, **caractérisée en ce qu'**elle comporte un deuxième dispositif d'aspiration (9), en aval du dispositif de sortie (8).

11. Installation selon l'une quelconque des revendications 1 à 10, **caractérisée en ce qu'**elle comporte un automate permettant de coordonner le fonctionnement de tout ou partie des éléments de l'installation.

12. Installation selon la revendication 11, **caractérisée en ce que** l'automate est apte à optimiser les débits de gaz injectés, gaz inerte et / ou mélange gazeux utilisé pour ladite opération, en fonction de mesures de teneur en oxygène permettant d'évaluer les entrées d'air, effectuées en différents points à l'intérieur de l'enceinte, et/ou en fonction d'une mesure de pression différentielle entre l'intérieur de l'enceinte et l'atmosphère environnante.

13. Installation l'une des revendications 1 à 12 **caractérisée en ce que** l'opération réalisée dans l'enceinte est une opération de réticulation d'un enduit tel qu'une encre ou un vernis par rayonnement Ultra Violet (« UV Curing ») ou par faisceau d'électrons (« Electron Beam »), en présence d'un mélange gazeux inerte.

14. Installation selon l'une des revendications 1 à 12 **caractérisée en ce que** l'opération réalisée dans l'enceinte est une opération de traitement de surface d'un substrat en défilement par une décharge électrique en présence dudit mélange gazeux pouvant dégager des effluents, l'installation comportant un support (1) de substrat contre une région duquel est appliqué le substrat, et des électrodes (33) à proximité du support formant contre-électrode, et **en ce que** l'enceinte (3), dans laquelle sont logées les électrodes, est adjacente au support sur au moins la largeur du substrat et le long d'au moins une partie de ladite région.

15. Installation selon la revendication 14 **caractérisée en ce qu'**elle comporte un collecteur d'alimentation en mélange gazeux (7) relié aux électrodes pour injecter au sein de celles-ci le mélange gazeux contre le substrat.

16. Installation selon la revendication 14 ou 15, **caractérisée en ce que** lesdits moyens pour injecter du gaz inerte en formant un couteau gazeux comprennent une fente d'injection de gaz à parois planes et débouchant à l'extérieur en vis-à-vis du support (1).

17. Installation selon l'une quelconque des revendications 14 à 16, **caractérisée en ce que** lesdits moyens pour créer une surpression refoulant le gaz en formant piston comprennent des gorges ouvertes en vis-à-vis du support (1) et formant un labyrinthe.

18. Installation selon l'une quelconque des revendications 14 à 17, **caractérisée en ce que** lesdits moyens pour canaliser comprennent un canal séparé par une cloison desdits moyens pour injecter le gaz inerte, et ouvert en vis-à-vis du support (1).

19. Installation selon l'une quelconque des revendications 14 à 18, **caractérisée en ce que** le support (1) de substrat est un rouleau tournant, et la région contre laquelle est appliqué le substrat (S) est une région en arc de cercle.

20. Installation selon l'une quelconque des revendications 14 à 19, **caractérisée en ce que** les moyens de régulation de débit aspiré comprennent une vanne de régulation (42) dans la conduite d'aspiration (41) débouchant dans l'enceinte (3), et un circuit de pilotage comprenant un capteur de pression pour commander la vanne.

21. Installation selon l'une quelconque des revendications 14 à 19, **caractérisée en ce que** les moyens de régulation de débit aspiré comprennent des moyens de régulation de la vitesse de rotation du ventilateur d'aspiration et un circuit de pilotage comprenant un capteur de pression pour commander la vitesse de rotation du ventilateur d'aspiration.

22. Installation selon l'une quelconque des revendications 14 à 21, **caractérisée en ce que** les électrodes (33) sont reliées à une alimentation dite haute tension et haute fréquence.

## Claims

1. Installation in which an operation is performed which requires control over the atmosphere inside a chamber (3), said operation being carried out in the presence of a gaseous mixture capable of releasing effluents, comprising:
- inlet and outlet device (5, 8) adjoining the chamber to oppose respectively an ingress of air into the chamber and an exit of gaseous effluents therefrom;
- a suction device (4) comprising a duct which leads into the chamber; and **characterised in that** it comprises:
- means (42) for regulating the flow rate of gas which is sucked in by said suction device, so as to maintain a pressure difference of approximately zero between the inside of the chamber and the surrounding atmosphere.

2. Installation according to claim 1, **characterised in that** the inlet device (5) comprises means (51) for injecting an inert gas by forming a gaseous knife upstream of the chamber, means (55) for creating an overpressure which forces the inert gas back away from the chamber by forming a piston which prevents air from entering the chamber, and means (56) for channelling the air away from the chamber.

3. Installation according to either claim 1 or claim 2, **characterised in that** the outlet device (8) comprises means (81) for injecting an inert gas by forming a gaseous knife downstream of the chamber, means (85) for creating an overpressure which forces the inert gas back towards the chamber by forming a piston opposing the transport of effluents out of the chamber, and means (86) for channelling towards the chamber any effluents leaving said chamber.

4. Installation according to either claim 2 or claim 3, **characterised in that** said means for injecting inert gas by forming a gaseous knife comprise a flat-walled gas-injection slot which leads to the inside of the inlet or outlet device concerned.

5. Installation according to any of claims 2 to 4, **characterised in that** said means for creating an overpressure which forces back the gas by forming a piston comprise grooves which are open opposite the interior space of the inlet or outlet device concerned and which form a labyrinth.

6. Installation according to any of claims 2 to 5, **characterised in that** said channelling means comprise a channel which is separated from said gas-injection means by a partition and open opposite the interior space of the inlet or outlet device concerned.

7. Installation according to any of claims 2 to 5, **characterised in that** said channelling means comprise a channel (56, 86) which is cut into a face of a plate (5C, 8C) which is separated from another piece (5A, 8A) by a space forming an inert-gas-injection slot (51, 81).

8. Installation according to either claim 6 or claim 7, **characterised in that** the ratio between the length and the height of the channel is at least 3, preferably at least 6.

9. Installation according to any of claims 1 to 8, **characterised in that** it further comprises lateral devices outside the chamber (3) which comprise at least means for creating an overpressure which forces the gas back away from the chamber by forming a piston which prevents air from entering the chamber and, where appropriate, also means for injecting an inert gas by forming a gaseous knife to the side of the chamber, and means for channelling the air away from the chamber.

10. Installation according to any of claims 1 to 9, **characterised in that** it comprises a second suction device (9) downstream of the outlet device (8).

11. Installation according to any of claims 1 to 10, **characterised in that** it comprises a controller which makes it possible to coordinate the operation of all or some of the elements of the installation.

12. Installation according to claim 11, **characterised in that** the controller is capable of optimising the flow rates of injected gases, inert gas and/or the gaseous mixture used for said operation, according to oxygen content readings which make it possible to evaluate the air intakes and are carried out at various points inside the chamber, and/or according to a reading of the differential pressure between the inside of the chamber and the surrounding atmosphere.

13. Installation according to any of claims 1 to 12, **characterised in that** the operation performed in the chamber is an operation for cross-linking a coating such as an ink or a varnish by means of ultraviolet radiation ("UV curing") or by means of an electron beam, in the presence of an inert gaseous mixture.

14. Installation according to any of claims 1 to 12, **characterised in that** the operation performed in the chamber is an operation for surface-treating a running substrate by means of an electric discharge in the presence of said gaseous mixture capable of releasing effluents, said installation comprising a substrate support (1), against a region of which the substrate is applied, and electrodes (33) in the vicinity of the support which forms a counter-electrode, and **in that** the chamber (3) accommodating the electrodes is adjacent to the support over at least the width of the substrate and along at least part of said region.

15. Installation according to claim 14, **characterised in that** it comprises a gaseous mixture feed header (7) which is connected to the electrodes in order to inject, within said electrodes, the gaseous mixture against the substrate.

16. Installation according to either claim 14 or claim 15, **characterised in that** said means for injecting inert gas by forming a gaseous knife comprise a flat-walled gas-injection slot which leads to the outside opposite the support (1).

17. Installation according to any of claims 14 to 16, **characterised in that** said means for creating an overpressure which forces back the gas by forming a piston comprise grooves which are open opposite the support (1) and which form a labyrinth.

18. Installation according to any of claims 14 to 17, **characterised in that** said channelling means comprise a channel which is separated by a partition from said means for injecting the inert gas and open opposite the support (1).

19. Installation according to any of claims 14 to 18, **characterised in that** the substrate support (1) is a rotating roller, and the region against which the substrate (S) is applied is an arc-shaped region.

20. Installation according to any of claims 14 to 19, **characterised in that** the means for regulating the sucked-in flow rate comprise a regulating valve (42) in the suction duct (41) leading into the chamber (3), and a pilot circuit for controlling the valve, which circuit comprises a pressure sensor.

21. Installation according to any of claims 14 to 19, **characterised in that** the means for regulating the sucked-in flow rate comprise means for regulating the rotational speed of the suction fan and a pilot circuit for controlling the rotational speed of the suction fan, which circuit comprises a pressure sensor.

22. Installation according to any of claims 14 to 21, **characterised in that** the electrodes (33) are connected to a so-called high-voltage and high-frequency power supply.

## Patentansprüche

1. Anlage, in der ein Vorgang durchgeführt wird, der eine Kontrolle der Atmosphäre im Inneren einer Umhüllung (3) erfordert, wobei der Vorgang in Gegenwart eines Gasgemisches erfolgt, das Abprodukte abgeben kann, aufweisend:
- eine Eintritts- und eine Austrittsvorrichtung (5, 8), die an die Umhüllung angrenzen, um einem Einströmen von Luft in die Umhüllung beziehungsweise einem Ausströmen gasförmiger Abprodukte aus dieser heraus entgegenzuwirken;
- eine Ansaugvorrichtung (4), die eine Leitung aufweist, die in die Umhüllung mündet, und **dadurch gekennzeichnet, dass** sie Folgendes aufweist:
- Mittel zum Regeln (42) des Durchsatzes des Gases, das von der Ansaugvorrichtung angesaugt wird, um zwischen dem Inneren der Umhüllung und der Umgebungsatmosphäre einen Druckunterschied von ungefähr null aufrechtzuerhalten.

2. Anlage nach Anspruch 1, **dadurch gekennzeichnet, dass** die Eintrittsvorrichtung (5) Mittel (51) zum Einblasen eines Inertgases durch Bilden einer Gasrakel vor der Umhüllung, Mittel (55) zum Erzeugen eines Überdrucks, der das Inertgas durch Bilden eines Kolbens, der das Einströmen von Luft in die Umhüllung verhindert, weg von der Umhüllung drückt, und Mittel (56) umfasst, um die Luft von der Umhüllung weg zu leiten.

3. Anlage nach Anspruch 1 oder 2, **dadurch gekennzeichnet, dass** die Austrittsvorrichtung (8) Mittel (81) zum Einblasen eines Inertgases durch Bilden einer Gasrakel hinter der Umhüllung, Mittel (85) zum Erzeugen eines Überdrucks, der das Inertgas durch Bilden eines Kolbens, der dem Transport der Abprodukte aus der Umhüllung heraus entgegenwirkt, in Richtung der Umhüllung drückt, und Mittel (86) umfasst, um die Abprodukte, die eventuell aus der Umhüllung gelangen, in Richtung derselben zu leiten.

4. Anlage nach Anspruch 2 oder 3, **dadurch gekennzeichnet, dass** die Mittel zum Einblasen von Inertgas durch Bilden einer Gasrakel einen Schlitz zum Einblasen von Gas mit ebenen Wänden umfassen, der ins Innere der betreffenden Eintritts- oder Austrittsvorrichtung mündet.

5. Anlage nach einem der Ansprüche 2 bis 4, **dadurch gekennzeichnet, dass** die Mittel zum Erzeugen eines Überdrucks, der das Gas durch Bilden eines Kolbens wegdrückt, Nuten umfassen, die gegenüber dem Innenraum der betreffenden Eintritts- oder Austrittsvorrichtung offen sind und ein Labyrinth bilden.

6. Anlage nach einem der Ansprüche 2 bis 5, **dadurch gekennzeichnet, dass** die Mittel zum Leiten einen Kanal umfassen, der von den Mitteln zum Einblasen von Gas durch eine Trennwand getrennt ist und gegenüber dem Innenraum der betreffenden Eintritts- oder Austrittsvorrichtung offen ist.

7. Anlage nach einem der Ansprüche 2 bis 5, **dadurch gekennzeichnet, dass** die Mittel zum Leiten einen Kanal (56, 86) umfassen, der in eine Seite einer Platte (5C, 8C) eingebracht ist, die durch einen Zwischenraum, der einen Schlitz (51, 81) zum Einblasen von Inertgas bildet, von einem anderen Teil (5A, 8A) beabstandet ist.

8. Anlage nach einem der Ansprüche 6 oder 7, **dadurch gekennzeichnet, dass** das Verhältnis zwischen der Länge und der Höhe des Kanals mindestens 3, vorzugsweise mindestens 6 entspricht.

9. Anlage nach einem der Ansprüche 1 bis 8, **dadurch gekennzeichnet, dass** sie ferner seitliche Vorrichtungen außerhalb der Umhüllung (3) aufweist, die mindestens Mittel zum Erzeugen eines Überdrucks, der das Gas durch Bilden eines Kolbens, der das Einströmen von Luft in die Umhüllung verhindert, weg von der Umhüllung drückt, und gegebenenfalls auch Mittel zum Einblasen eines Inertgases durch Bilden einer Gasrakel seitlich von der Umhüllung, sowie Mittel umfasst, um die Luft von der Umhüllung weg zu leiten.

10. Anlage nach einem der Ansprüche 1 bis 9, **dadurch gekennzeichnet, dass** sie eine zweite Ansaugvorrichtung (9) hinter der Austrittsvorrichtung (8) aufweist.

11. Anlage nach einem der Ansprüche 1 bis 10, **dadurch gekennzeichnet, dass** sie eine Steuerung aufweist, die die Koordinierung der Funktionsweise der gesamten oder eines Teils der Elemente der Vorrichtung ermöglicht.

12. Anlage nach Anspruch 11, **dadurch gekennzeichnet, dass** die Steuerung in der Lage ist, den Durchsatz der eingeblasenen Gase, Inertgas und/oder Gasgemisch, das für den Vorgang verwendet wird, in Abhängigkeit von Messungen des Sauerstoffgehalts, anhand derer das Einströmen von Luft bemessen werden kann und die an verschiedenen Stellen im Inneren der Umhüllung durchgeführt werden, und/oder in Abhängigkeit von einer Messung des Druckunterschieds zwischen dem Inneren der Umhüllung und der Umgebungsatmosphäre zu optimieren.

13. Anlage nach einem der Ansprüche 1 bis 12, **dadurch gekennzeichnet, dass** der Vorgang, der in der Umhüllung durchgeführt wird, ein Vorgang zum Vernetzen einer Beschichtung wie einer Farbe oder einem Lack durch Ultraviolettbestrahlung ("UV Curing") oder durch Elektronenstrahlen ("Electron Beam") in Gegenwart eines Inertgasgemischs ist.

14. Anlage nach einem der Ansprüche 1 bis 12, **dadurch gekennzeichnet, dass** der Vorgang, der in der Umhüllung durchgeführt wird, ein Vorgang zur Oberflächenbehandlung eines vorbeilaufenden Substrats durch eine elektrische Entladung in Gegenwart des Gasgemischs, das Abprodukte abgeben kann, ist, wobei die Anlage einen Substratträger (1) aufweist, wobei das Substrat an einen Bereich desselben angelegt ist, und Elektroden (33) in der Nähe des Trägers, der eine Gegenelektrode bildet, und dadurch, dass die Umhüllung (3), in der die Elektroden untergebracht sind, zumindest über die Breite des Substrats und mindestens entlang eines Abschnitts des Bereichs an den Träger angrenzt.

15. Anlage nach Anspruch 14, **dadurch gekennzeichnet, dass** sie einen Verteiler zur Versorgung mit dem Gasgemisch (7) aufweist, der mit den Elektroden verbunden ist, um innerhalb derselben das Gasgemisch gegen das Substrat zu blasen.

16. Anlage nach Anspruch 14 oder 15, **dadurch gekennzeichnet, dass** die Mittel zum Einblasen von Inertgas durch Bilden einer Gasrakel einen Schlitz zum Einblasen von Gas mit ebenen Wänden umfassen, der außerhalb gegenüber dem Träger (1) mündet.

17. Anlage nach einem der Ansprüche 14 bis 16, **dadurch gekennzeichnet, dass** die Mittel zum Erzeugen eines Überdrucks, der das Gas durch Bilden eines Kolbens wegdrückt, Nuten umfassen, die gegenüber dem Träger (1) offen sind und ein Labyrinth bilden.

18. Anlage nach einem der Ansprüche 14 bis 17, **dadurch gekennzeichnet, dass** die Mittel zum Leiten einen Kanal umfassen, der von den Mitteln zum Einblasen des Inertgases durch eine Trennwand getrennt ist und gegenüber dem Träger (1) offen ist.

19. Anlage nach einem der Ansprüche 14 bis 18, **dadurch gekennzeichnet, dass** der Substratträger (1) eine sich drehende Walze ist und der Bereich, an den das Substrat (S) angelegt ist, ein kreisbogenförmiger Bereich ist.

20. Anlage nach einem der Ansprüche 14 bis 19, **dadurch gekennzeichnet, dass** die Mittel zum Regeln des Ansaugdurchsatzes ein Regelventil (42) in der Ansaugleitung (41), die in die Umhüllung (3) mündet, und eine Steuerschaltung zum Steuern des Ventils umfassen, die einen Drucksensor umfasst.

21. Anlage nach einem der Ansprüche 14 bis 19, **dadurch gekennzeichnet, dass** die Mittel zum Regeln des Ansaugdurchsatzes Mittel zum Regeln der Drehzahl des Sauglüfters und eine Steuerschaltung zum Steuern der Drehzahl des Sauglüfters umfassen, die einen Drucksensor umfasst.

22. Anlage nach einem der Ansprüche 14 bis 21, **dadurch gekennzeichnet, dass** die Elektroden (33) mit einer sogenannten Hochspannungs- und Hochfrequenzversorgung verbunden sind.
